# EUROPEAN PATENT APPLICATION

(11) **EP 3 471 213 A1**
(43) Date of publication of application: **17.04.2019**
(21) Application number: 18159728.7
(22) Date of filing: 02.03.2018
(51) Int. Cl.: H01R 11/30, H01R 24/38, B60L 11/18, H01R 13/62

(54) **APPARATUS AND METHODS FOR VEHICLE BATTERY CHARGING OR VOLTAGE MONITORING**

(30) Priority: 10.10.2017 AU 2017904077
(71) Applicant: Shenzhen Prime Logic Technology Co., Ltd., 518128 Shenzhen City, Guangdong (CN)
(72) Inventor: NG, Cleo Man Oi, Shenzhen City, Guangdong 518128 (CN)
(74) Representative: Walker, Ross Thomson

(57) **Abstract**

The present invention relates generally to connectors used in battery charging systems. An electrical connector is provided comprising a first conducting portion configured to conduct sufficient electrical energy to charge or maintain or monitor the voltage of a vehicle rechargeable battery, and a magnetically attractive portion configured to be attracted to a complementary magnetically attractive portion on another connector. Also provided is a connection system for connecting a rechargeable vehicle battery to a power supply or a battery monitor, the system comprising a first connector and a second connector, wherein the first connector and second connector are each configured to form a mutual magnetic coupling, the coupling being such that an electrical connection is made between the first and second connectors. The present invention is suitable for electrically cranked engines such as those found in passenger vehicles, commercial vehicles, motorcycles, agricultural machinery, recreational vehicles, motor boats and the like. The invention may also be useful in charging a battery in electrically-powered vehicles such as golf carts, mobility scooters, two-wheeled scooters, passenger vehicles, commercial vehicles, bicycles, toy vehicles, wheelchairs and the like.

## Description

### FIELD OF THE INVENTION

The present invention relates generally to connectors used in battery charging systems. More particularly, the invention relates to connector hardware for carrying electrical energy from an electrical power supply to a vehicle battery in need to charging. The present invention is suitable for (but not limited to) electrically cranked engines such as those found in passenger vehicles, commercial vehicles, motorcycles, agricultural machinery, recreational vehicles, motor boats and the like. The invention may also be useful in charging a battery in electrically-powered vehicles such as golf carts, mobility scooters, two-wheeled scooters, passenger vehicles, commercial vehicles, bicycles, toy vehicles, wheelchairs and the like.

### BACKGROUND TO THE INVENTION

Batteries which store electrical energy are found on a large range of vehicles. In many circumstances the vehicle is driven by an internal combustion engine which is cranked (started) by an electric motor, with the electric motor being powered by a storage battery. In many instances, the battery relies on lead/acid chemistry that is recharged by an alternator while the combustion engine is in operation. A problem arises in that parasitic load on the vehicle's circuit can deplete the battery to the point that it is not fully charged during operation of the combustion engine. The parasitic load may be caused by the operation of electronic componentry such as entertainment systems, navigation systems, safety systems (such as collision avoidance and tyre pressure monitoring systems). For vehicles having fuel saving stop/start ignitions systems the problem of battery depletion is particularly acute. Accordingly, it is not uncommon for the vehicle battery to be depleted to the point that it is incapable of cranking the combustion engine. The engine must then be started using an external power source such as a jump starter.

A further problem is that the depletion of lead/acid batteries has a negative effect on the battery *per se.* Where a battery is not maintained in a well-charged charge, or allowed to completely discharge, small sulfate crystals form which deposits on the negative plates of the battery. This leads to the development of large crystals that reduce the ability of the battery to store and delivery electrical power when required. This process is known as "sulfation" and is the main cause of early battery failure.

With improvements in storage battery technology, electrically powered vehicles are becoming more practical, affordable and therefore also more common. In such vehicles, a rechargeable battery of some description is connected to an electrical motor which drives the vehicle wheels. The vehicle is driven around by the user, and in the course of use the battery discharges an eventually becomes depleted.

To maintain or recharge the vehicle battery, the user typically connects the rechargeable battery to a power source while the vehicle is parked. The power source may be a mains power source (which is typically down-converted to an appropriate voltage, and to direct current), another battery, or even a renewable power source such as a bank of photovoltaic solar panels. Generally, the power source is fitted with an electrical connector which is configured to couple to a connector of the vehicle.

For lead/acid batteries, a pair of alligator clips are typically connected directly to the battery poles during maintaining or recharging. This requires access to the battery (often disposed in the engine bay, or in the trunk area), and is generally inconvenient.

For electrically driven vehicles, an external facing connector is typically used to connect a charger. Often, the connectors on the charger comprises at least two pins (one electrically positive, and the other negative) and the connector on the vehicle side comprises a socket with the electrical connection made between the charger and the vehicle battery when the user inserts the pins into the socket. The pins are typically retained in the socket due to frictional engagement between the pin and socket, or between complementary fittings of the two connector housings. In some cases, a specific locking mechanism (such as a biased latch arrangement) is incorporated into a connector housing to ensure the housings remain coupled and the electrical connection is not inadvertently broken.

Regardless of the configuration of the connectors, an electrical cable is generally used to carry electrical energy from the power source to the vehicle. The cable may be integral with and extend from the vehicle, with a pin-type connector being attached to the terminus of the cable. When recharging is required, the cable is pulled by the user from the vehicle and the connector inserted into a wall-mounted socket.

Alternatively, the vehicle may be fitted with a socket-type connector which is integrated with or otherwise mounted on the vehicle. A flexible cable extends from the power supply (such as a mains power supply), the cable being fitted with a complementary pin-type connector at the terminus. When recharging is required, the cable is pulled by the user toward the vehicle and the pin-type connector inserted into the vehicle socket.

As another alternative, both vehicle and power supply connectors are fitted to the end of flexible cable and the two connectors are coupled at a point in space between the vehicle and the power outlet.

Many prior art connectors have one or more problems. One problem is that users forget to disconnect the power supply before driving the vehicle. It is often the case that the vehicle battery requires charging over any extended period (such as overnight) and by the time the user returns to use the vehicle, any memory of having connected the vehicle is diminished or lost. Accordingly, the user may simply sit in the vehicle and drive away with the electrical connection still intact. Once the cable involved in the electrical connection is pulled taught, any further driving causes force to be applied to the cable and the connectors. Where the connectors are loosely coupled together (for example, by way of an interference or friction fit) the connectors may simply decouple under the applied force. Even in such decoupling, some force is applied to the connectors and cable which, over time, may be incrementally damaged to the point of eventual failure. Even before complete failure, the connection may become unreliable over time, and in some instances may even present a fire hazard due to arcing.

Where the connectors are robustly coupled (for example, where a latch arrangement is used to secure the connectors together) significant damage to the vehicle or power supply will occur if the user drives away without first decoupling the connectors. A connector may be ripped away from the cable to which it is fitted, this causing a significant electric shock hazard given the exposure of wires where mains voltages are involved. In more extreme circumstances, forces may be applied to the battery under charge, or to other components of the vehicle such as an exterior vehicle panel. On some occasions, a socket mounted on a building may be ripped from the wall onto which it is attached.

In seeking to avoid the problems described above, some prior art connectors are configured to be easily uncoupled . Such connectors are, of course, prone to inadvertent disconnection by the connectors being uncoupled by even a gentle knock, or a disturbance by the wind. If disconnected, the user is presented with a vehicle which has not charged at all or has incompletely charged. Furthermore, while a loose connection is relatively easy to uncouple by a user, such connections can lead to a drop in voltage over the connection and an increase in heat.

Quite apart from the aforementioned problems, prior art connectors can be difficult for users to connect and disconnect. Where coupling of connectors is facilitated by friction or interference fitting, there may be some difficulty in pushing the two connectors with sufficient force so as to ensure robustness of the coupling. Where sufficient force is used, some strength may be required to uncouple the connectors, this being exacerbated where parts of the connectors have thermally expanded by virtue of heat generated by the electric current passing through the connectors. Such issues may be addressed by latch-type connectors, however the problems of a damage caused by a user forgetting to uncouple the connectors before driving away will arise, as described *supra.*

It is a further problem in the art to monitor the charge status of a vehicle battery. Some individuals will wish to know the charge status in order to decide whether or not charging, or further charging, is required. In some instances, the monitoring data may reassure a user that the vehicle battery has sufficient charge, and the charging regime being implemented is sufficient to prevent failure of the vehicle to start. Particularly in colder climates, knowledge that a vehicle battery is fully charged may alleviate any anxiety on the part of the user.

It is an aspect of the present invention to overcome of ameliorate a problem of the prior art by providing connectors that are capable of easily coupling and uncoupling, and also of forming a robust connection between a rechargeable electric vehicle and a power supply that does not lead to any damage if a user neglects to uncouple the connectors before driving away.

The discussion of documents, acts, materials, devices, articles and the like is included in this specification solely for the purpose of providing a context for the present invention. It is not suggested or represented that any or all of these matters formed part of the prior art base or were common general knowledge in the field relevant to the present invention as it existed before the priority date of each claim of this application.

### SUMMARY OF THE INVENTION

In a first aspect, but not necessarily the broadest aspect, the present invention provides an electrical connector for charging or monitoring a vehicle battery, the electrical connector comprising a first conducting portion configured to conduct sufficient electrical energy to charge or maintain or monitor the voltage of a vehicle rechargeable battery, and a magnetically attractive portion configured to be attracted to a complementary magnetically attractive portion on another connector.

In one embodiment of the first aspect, the first conducting portion is disposed on or over a surface of the magnetically attractive portion.

In one embodiment of the first aspect, the magnetically attractive portion is also the first conductive portion.

In one embodiment of the first aspect, the first conductive portion is a metallic plate disposed on or over a surface of the magnetically attractive portion.

In one embodiment of the first aspect, in use, the first conductive portion conducts negative charge.

In one embodiment of the first aspect, the electrical comprises a second conducting portion which, in use, conducts a charge opposite to that of the first conducting portion.

In one embodiment of the first aspect, the second conducting portion is a male conducting portion.

In one embodiment of the first aspect, the male conducting portion extends outwardly from the connector and extends beyond the first conducting portion.

In one embodiment of the first aspect, the male conducting portion is biased outwardly.

In one embodiment of the first aspect, the second conducting portion is a female conducting portion.

In one embodiment of the first aspect, the second conducting portion comprises a space adapted to receive a male conducting portion.

In one embodiment of the first aspect, the second conducting portion is disposed adjacent to the magnetically attractive portion.

In one embodiment of the first aspect, the magnetically attractive portion partially or completely surrounds the second conductive portion

In one embodiment of the first aspect, the first conductive portion partially or completely surrounds the second conductive portion.

In one embodiment of the first aspect, the electrical connector is associated with a housing of a connector associated with a processor or electronic memory of a vehicle.

In one embodiment of the first aspect, the processor or electronic memory is part of an engine management system of a vehicle.

In one embodiment of the first aspect, the connector associated with a processor or electronic memory of a vehicle is an on-board diagnostics (OBD) connector.

In one embodiment of the first aspect, the connector associated with a processor or electronic memory comprises a ground (chassis) connection and a battery connection, and the first connector is in electrical connection with the ground (chassis) connection and/or the second connector is in electrical connection with the battery connection and/or the second connector is in electrical connection with the ground (chassis) connection and/or the first connector is in electrical connection with the battery connection.

In one embodiment of the first aspect, the magnetically attractive portion is a magnet or a magnetisable metal.

In a second aspect, the present invention provides a connection system for connecting a rechargeable vehicle battery to a power supply or a battery monitor, the system comprising a first connector of any embodiment of the first aspect and a second connector of any embodiment of the first aspect, wherein the first connector and second connector are each configured to form a mutual magnetic coupling, the coupling being such that an electrical connection is made between the first and second connectors.

In one embodiment of the second aspect, the magnetically attractive portion of the first connector is a magnet, and the magnetically attractive portion of the second connector is a magnet having an opposite polarity to the magnet of the first connector.

In a third aspect there is provided a vehicle having a rechargeable battery, the rechargeable battery being in electrical connection with the connector of any embodiment of the first aspect.

In a fourth aspect of the present invention there is provided a power supply for charging the battery of a vehicle, the power supply being in electrical connection with the connector of any embodiment of the first aspect.

In a fifth aspect, the present invention provides a method of charging a vehicle battery, the method comprising the steps of: connecting the connector of the power supply of the fourth aspect to the connector of the vehicle of the third aspect by causing or allowing the magnetically attractive portions of the first and second connectors to contact, or nearly contact each other such that the conductive portions of the first and second connectors form an electrical connection, and allowing electrical current to flow from the power supply to the vehicle rechargeable battery.

In one embodiment of the fifth aspect, the method comprises the step of the user manually breaking the magnetic attraction between the magnetically attractive portions of the first and second connectors after a period.

In a sixth aspect, the present invention provides a device for monitoring the battery of a vehicle, the device comprising an electrical and/or electronic means for detecting a battery parameter being in electrical connection with the connector of any embodiment of the first aspect.

In one embodiment of the fifth aspect, the battery parameter is battery voltage.

In a seventh aspect, the present invention provides a method of monitoring a parameter of a vehicle battery, the method comprising the step of connecting the device of the sixth aspect to a vehicle battery.

In a seventh aspect, the present invention provides a method of providing a recharging or a monitoring port to a vehicle having a rechargeable battery, the method comprising the step of securing the electrical connector of any embodiment of the first aspect to a vehicle.

In one embodiment of the seventh aspect, the method comprises the step of connecting a rechargeable battery of the vehicle to the electrical connector.

### BRIEF DESCRIPTION OF THE FIGURES

FIG. 1A shows a cross-sectional diagrammatic representation of a preferred female connector of the present invention.
FIG. 1B shows a cross-sectional diagrammatic representation of a preferred male connector of the present invention, the male connector being configured to couple with the female connector shown in FIG. 1A.
FIG. 1C is a perspective drawing of a housing comprising a female connector constructed generally according to the diagram of FIG. 1A. The housing is intended to be inserted through an aperture in a vehicle panel so as to present the connecting portions to the environment.
FIG. 1D is a perspective drawing of a housing comprising a male connector constructed generally according to the diagram of FIG. 1B. The connector of this figure is intended to be coupled to the connector shown in FIG. 1C
FIG. 2A shows a cross-sectional diagrammatic representation of a further preferred female connector of the present invention.
FIG. 2B shows a cross-sectional diagrammatic representation of a further preferred male connector of the present invention, the male connector being configured to couple with the female connector shown in FIG. 2A.
FIG. 3 is a diagrammatic representation of a vehicle battery charging system using the connectors of FIG. 1C and FIG. 1D.
FIG. 4A is drawing showing a connector of the present invention that is configured to attach and make electrical connection with a vehicle OBD-II port.
FIG. 4B is a drawing showing the implementation of the OBD-II compliant housing of FIG. 4A in the context of a vehicle. The arrow points to the internal cabin of the vehicle, and to a region under the dash where the vehicle OBD-II port is often located.

### DETAILED DESCRIPTION OF THE INVENTION AND PREFERED EMBODIMENTS

After considering this description it will be apparent to one skilled in the art how the invention is implemented in various alternative embodiments and alternative applications. However, although various embodiments of the present invention will be described herein, it is understood that these embodiments are presented by way of example only, and not limitation. As such, this description of various alternative embodiments should not be construed to limit the scope or breadth of the present invention. Furthermore, statements of advantages or other aspects apply to specific exemplary embodiments, and not necessarily to all embodiments covered by the claims.

Throughout the description and the claims of this specification the word "comprise" and variations of the word, such as "comprising" and "comprises" is not intended to exclude other additives, components, integers or steps.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may.

It will be understood that while certain advantages of the invention are described herein it is not represented that all embodiments of the invention will possess all advantages. Some embodiments of the invention may provide no advantage whatsoever and may represent no more than an alternative to the prior art.

The present invention is predicated at least in part on Applicant's discovery that magnetic attraction is a useful force in the coupling of connectors used to connect a vehicle battery to a charging power supply. It has been found that magnetic attraction between connectors can be used and adjusted so as to be sufficiently strong such that inadvertent decoupling is avoided, while decoupling without damage to the connectors, vehicle or the charging power supply is provided where the vehicle is driven away without the user firstly disconnection the charging power supply. If a connector is subject to a significant pulling force, it will readily decouple from its pair thereby avoiding damage to itself and also associated hardware.

Apart from the avoidance of damage, magnetically coupled connectors are relatively easy to couple by a user given that the magnet(s) act to pull the connectors toward each other. Thus, the user need only place the connectors in mutual proximity and the attractive forces cause the connectors to snap together almost instantaneously.

In some embodiments, the magnet(s) are arranged so as to facilitate the alignment of the connectors such that, for example, an outwardly extended male portion of one connector is aligned coaxial with a female receiving portion on another connector. Each connector may comprises identical ring magnets (although of opposite magnetic polarity) with male or female connection parts being disposed at the centre of each ring magnet. As the two ring magnets align coaxially (by virtue of the strong attraction between the north and south poles of the magnets) the male and female parts disposed at the centre are also coaxially aligned so as to facilitate insertion of the male part into the female part.

Decoupling the connectors may be achieved by a user simply pulling one connector away from the other until the magnetic attraction is broken.

Magnet polarity in the connectors may be configured so as to prevent the coupling of incompatible connectors. For example, a golf course use golf carts running on either 36 V or 48 V, and must take care to prevent a 36 V charger being used on a 48 V cart, and *vice versa.* In that circumstance the magnet of the female connector on the 48 V cart may be outwardly north, and the magnet of the male connector on the 48 V cart may be outwardly south, and the magnet of the female connector on the 36 V cart may be outwardly south, and the magnet of the male connector on the 48 V cart may be outwardly north. If an attempt is made to couple the male connector (having an outwardly south magnet) of the 48 V charger with the female connector (having an outwardly south magnet) of the 36 V charger, the connectors will repel each other thereby preventing coupling.

The use of magnets in the present connectors also provides in one embodiment, a support for a planar electrically conducting portion, such as plate, with a magnet disposed behind the plate acting to force the plate against a similar plate and magnet arrangement on a paired connector. In this way, two electrically conducting plates are essentially sandwiched between two magnets, the mutual attraction of the magnets acting to ensure sound contact between the plates. The plates are preferably fabricated from an electrically conductive material which is highly electrically conductive as well as resistant to oxidation or other process of corrosion. Metals such as stainless steel or copper may be used.

Thus, magnetic attraction is able to provide a desired balance between the avoidance of inadvertent uncoupling and ease of manual uncoupling, while also providing for a self-alignment capability.

The magnets in the preferred embodiments are ring-shaped, however it is to be appreciated that other geometries are contemplated. A magnet may be only a portion of a ring (for example comprise two substantially semicircular portions of a ring magnet, or four quadrant portions of a ring magnet with each portion being discrete. Alternatively, only a semicircular portion or a quadrant portion may be used.

Other than rings and portions thereof, the magnet may be a triangle, square, pentagon, hexagon, heptagon, octagon or other polygon, ovoid, or even irregular. Portions of these various shapes are also contemplated to be useful in the context of the invention.

Alternatively, the magnet may be plate-like, such as a circular disc or a square tile. One or more apertures may extend therethrough to allow for a male or female part to extend through or into the body of plate.

In some embodiments, one or more conducting portions are arranged peripheral to the magnetically attractive portion of the connector. As a further alternative, a conducting portion may be disposed within the periphery of magnetically attractive portion with one disposed outside the periphery of the same magnetically attractive portion.

The magnetic attraction of a connector may be utilised also to safely secure it when not in use. For example, a male connector may be disposed at the terminus of wire, and when not in use the connector may be left on the ground and become damaged. As a further embodiment, a wall-mounted charger housing (which supplies the connector with power) may have a metallic or magnetic region allowing a user to magnetically attach the male connector thereto. By this arrangement, the male connector is maintained in a safe position, and therefore less liable to be damaged when not in use.

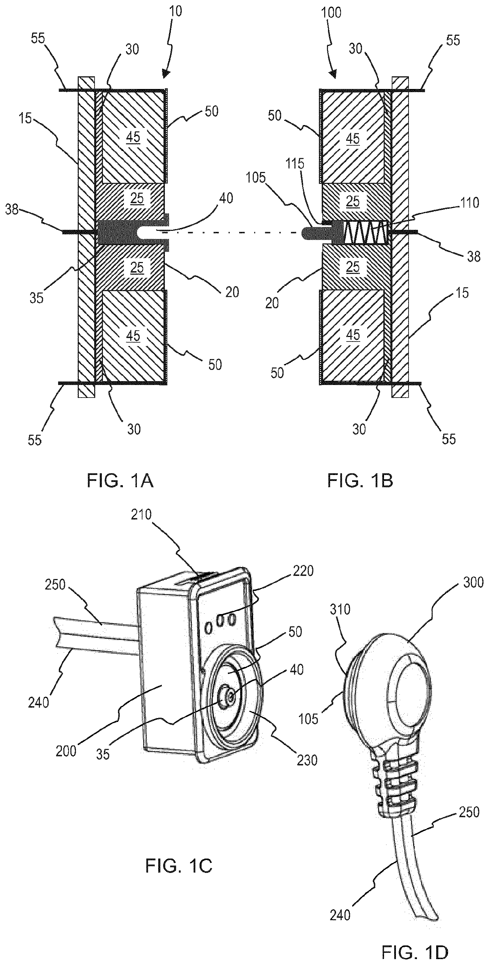

Turning now to the first Figure page there are shown exemplary embodiments of both male and female connectors of the present invention. A diagrammatic cross-section of a female connector 10 is shown at Fig. 1A, the components of which are generally mounted on a circuit board 15. Disposed on the circuit board 15 is an electrically insulating support 20 which is generally circular, and having a central cylindrical protrusion 25 surrounded by an annular planar region 30. The cylindrical protrusion 25 is fabricated from a mouldable polymer, such as a polyethylene. A cylindrical hollow extends axially into the central cylindrical protrusion 25, the hollow being shaped and dimensioned so as to snugly receive a generally cylindrical pin receiving portion 35 defining a generally cylindrical space 40, the space 40 having a bowl-like inner terminus. The pin receiving portion 35 is fabricated from an electrically conductive metal, and has a conductive tab 38 in electrical connection therewith. The function of the pin receiving portion 35 is to establish sound electrical contact with a pin of the male connector shown at Fig. 1B, as will be more fully described *infra.*

Encircling the pin receiving portion 35 and cylindrical protrusion 25 is a ring magnet 45. The ring magnet 45 is a permanent magnet of the ferrite type, and in not electrically conductive. The left-hand face (as drawn) of the ring magnet 45 abuts the planar region 30 of the insulating portion 20. The function of the ring magnet 45 is to establish magnetic coupling with a similar magnet (but of opposing polarity) of the male connector shown at Fig. 1B, as will be more fully described *infra.*

In the female connector of Fig. 1A there is a ring-shaped plate 50 which is shaped and dimensioned so as to completely cover the ring magnet 45 with which it abuts. The ring-shaped plate 50 is fabricated from an electrically conductive metal, and functions so as to establish sound electrical contact with an identically formed component of the male connector shown at Fig. 1B. The ring-shaped plate 50 has associated conductive tabs 55 which act to (i) conduct current to or from the plate 50, and (ii) facilitate mounting on the circuit board 15.

Turning now to Fig, 1B, this drawing shows a male connector 100 configured to electrically couple to the female connector of Fig. 1A. Components of the male connector 100 that are analogous to components of the female connector 10 are marked congruously. The connector 100 comprises a pin 105 fabricated from an electrically conducting material (such as a metal) and is in slidable engagement with a cylindrical axial hollow formed in the cylindrical protrusion 25. The pin 105 is biased outwardly (toward the left, as drawn) so as to normally extend away from the connector 100 as a hole, and clear of the ring-shaped plate 50. The outward bias of the pin 105 is provided by a metallic compression spring 110, which is itself conductive and soldered at a first end to the back face of the pin 105. The second end of the spring 110 makes electrical connection to the conductive tab 45. Disposed at the entrance to the hollow is a stop member 115 which prevents the pin 105 from being ejected completely from the connector 100 by the spring 110.

Considering now the electrical coupling of the female 10 and male 100 connectors, the connectors 10 and 100 are opposed as shown in Figs. 1A and 1B and brought together by a user. In bringing the connectors 10 and 100 together, the mutual attraction of the ring magnet 25 of the female connector 10 to the ring magnet 25 of the male connector 100 acts to align the axes of the connectors 10 and 100 so as to facilitate the insertion of pin 105 into the space 40.

The magnetic attraction between the ring magnets 45 of the female 10 and male 100 connectors causes the connectors to almost instantaneously couple when positioned sufficiently mutually proximal. Once coupled, the ringed shaped plates 50 of the female 10 and male 100 connectors are brought into mutual contact, with electrical current being able to flow from one plate 50 to the other plate 50 to form a negative polarity connection.

Once coupled, the pin 105 inserts into the pin receiving portion 35 of the female connector 10 so as to substantially fully occupy the space 40. The pin 105 has sufficient length so as ensure its tip contacts the bowl-shaped terminus of the space 40, and by virtue of the spring 110 is constantly urged against the terminus so as ensure good electrical contact is made between the components to form a positive polarity connection. It will be appreciated that the force exerted by the spring 110 is not so great as to break the magnetic attraction between the ring magnets 45 of the female 10 and male 100 connectors.

The mutual attraction between the ring magnets 45 of the female 10 and male 100 connectors is sufficient so as to ensure that the connectors are not inadvertently uncoupled during charging. At the same time, the attraction is preferably not so great such that difficulty arises for a user seeking to manually uncouple the connectors 10 and 100.

The attraction between the connectors 10 and 100 may be increased by using very strong magnets (such as rare earth magnets). Relatively weak attraction may be provided by the use of weakly magnetised ferrite magnets. Alternatively only one connector of the pair 10, 100 may have a magnet, with the other connector having a metallic ring structure in place of the ring magnet.

Given the benefit of the present specification, the skilled person will be enabled by routine means only to configure the connectors to have a suitable level of mutual magnetic attraction according to the proposed circumstances of use.

The supply current for recharging the vehicle battery may be provided by either male or female connector type. Similarly, the connector on the vehicle side may be either male or female type. In any event, the electrical power provided by the power supply is conducted to the conductive tabs 38 and 55.

For example, the positive terminal of the power supply may be in electrical connection with the tab 38 and the negative terminal being in electrical contact with the tab 55. By this arrangement, the plate 50 has a negative potential and the pin 105 or pin receiving portion 35 has a positively potential.

The tabs 38 and 55 in this preferred embodiment pass through the circuit board 15 and may be physically anchored to and brought into electrical connection therewith by way of solder. Where the intention is for the plate 50 to be biased negatively, the tabs 55 are soldered to a portion of the circuit board that is in electrical connection with the ground of the circuit board.

The circuit board 15 comprises other components including resistors, transistors, diodes, capacitors, swishes, LEDs, integrated circuits and the like which may contribute to the charging function of the connector. For example, the circuit board of a connector may comprise circuitry which monitors (and optionally regulates) the voltage applied to the vehicle battery. Other useful circuity may include LEDs which light only when proper electrical connection has been made between connectors, or to show the level of charge in the vehicle battery.

Reference is now made to Fig. 1C which shows a preferred female connector of the present invention in the context of a housing, the connector being constructed broadly in accordance with the diagrammatic representation of Fig. 1A. The embodiment of Fig. 1C comprises a plastic housing 200 which contains within the circuit board 15 (not shown), but presents to the outside the conducting plate 50 (being the negative contact in this embodiment) and the pin receiving portion 35 (being the positive contact in this embodiment). The housing 200 is configured to insert into an aperture of, for example, a vehicle panel and is retained within the aperture by resiliently deformable plastic tabs (the first of which is marked 210, with the second not visible in this view but present on the opposing face of the housing). A series of LEDs (one of which is marked 220) are provided on the outwardly facing surface of the housing 200, which are configured to indicate various parameters such as the charge level of the vehicle battery, the presence or absence or current, etc. The housing 200 further includes an annular flange 230 which surrounds the ring-shaped plate 50. Extending from the rear of the housing are two wires 240, 250 which carry positive and negative charge respectively. In this embodiment, the negative wire 250 is connected at one end to the negative pole of the vehicle battery (not shown) and at the other end to the negative connection of the circuit board 15 which is in turn connected to the ring-shaped plate 50. The positive wire 240 is connected at one end to the positive pole of the vehicle battery (not shown) and at the other end to the positive connection of the circuit board 15 which is in turn connected to the pin receiving portion 35.

Reference is now made to Fig. 1D which shows a preferred male connector of the present invention in the context of a housing, the connector being constructed broadly in accordance with the diagrammatic representation of Fig. 1B. The embodiment of Fig. 1D comprises a plastic housing 300 which contains the circuit board 15 (not shown), but presents to the outside the conducting ring-shaped conducting plate 50 (not shown, but being the negative contact in this embodiment) and the pin 105 (being the positive contact in this embodiment). The housing 300 is configured to be held in the hand of a user. The housing 300 further includes an annular flange 310 which surrounds the ring-shaped plate 50. The flange 310 is configured to be guided by the user into the space formed by the annular flange 230 of the connector of Fig. 1C Extending from the rear of the housing are two wires 240, 250 which carry positive and negative charge respectively. In this embodiment, the negative wire 250 is connected at one end to the negative pole of the power supply (not shown) and at the other end to the negative connection of the circuit board 15 which is in turn connected to the ring-shaped plate 50. The positive wire 240 is connected at one end to the positive pole of the power supply (not shown) and at the other end to the positive connection of the circuit board 15 which is in turn connected to the pin receiving portion 35.

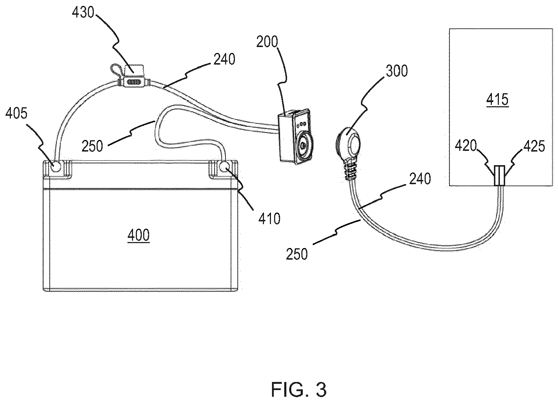

In use, once the user locates the annular flange 310 within the slightly larger annular flange 230, the magnets of each connector attract causing the pin 105 to enter the space 40 of the pin receiving portion 35 (thereby forming an electrical connection between the positive pole of the vehicle battery and the positive pole of the power supply) and the two ring-shaped plates to make contact (thereby forming an electrical connection between the negative pole of the vehicle battery and negative pole of the power supply). With the connections made between the vehicle battery and power supply, the battery commence charging. Once charging is complete, the user gently tugs on the wires 240, 250 of the male connector of Fig 1D so as to separate it from the female connector of Fig 1C. The charging arrangement is shown more clearly at Fig. 3, detailing the vehicle battery 400, having a positive pole 405 and a negative pole 410; and the power supply 415 having a positive pole 420 and a negative pole 425. Also shown is a fuse 430 wired inline on the wire 240.

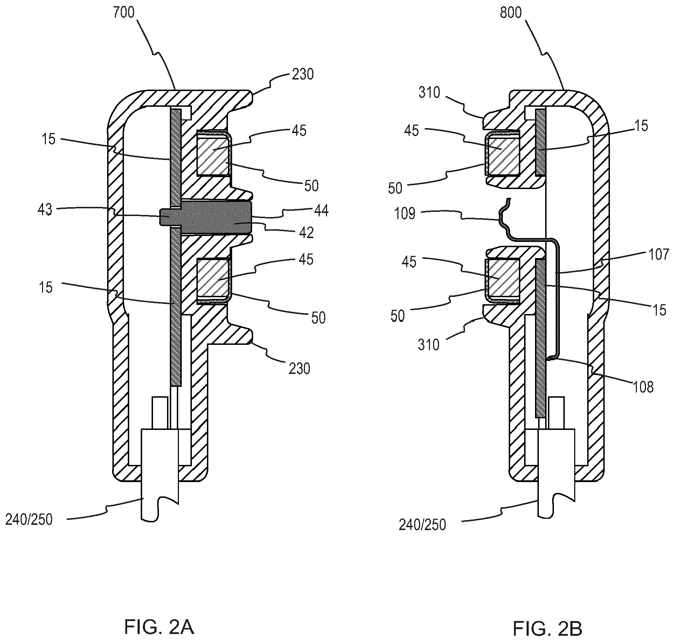

A further preferred embodiment is shown in Figs. 2A and 2B. These drawings are numbered generally in accordance with the embodiments of Figs. 1A, 1B, 1C and 1D. The embodiment of Figs. 2A and 2B do not rely on the insertion of a pin of the male connector into a space of the female connector. Instead, the male connector 800 of this embodiment has a metallic ribbon 107 having a lower terminal 108 soldered into the circuit board 15, and an upper region bent to form a male contact surface 109. The female connector 700 has a cylindrical metallic structure 42 having a terminal 43 soldered into the circuit board 15. A female contact planar surface 44 is provided, and is adapted to form an electrical connection with the male contact surface 109 when brought into proximity therewith. The metallic ribbon 107 is resilient such that the male contact surface 109 is biased outwardly (i.e. to the left, as drawn) such that when the female contact surface 44 is brought to bear against it the male contact surface 109 is urged against the bias, and toward the right (as drawn). The magnetic attraction between the connectors 700, 800 prevents the resilience of the metallic ribbon 107 from forcing the connectors 700 and 800 apart. Instead, the connectors 700 and 800 remain in contact by virtue of the magnetic attraction, with the male contact surface 109 urging against the female contact surface 44 so as to maintain electrical contact therewith.

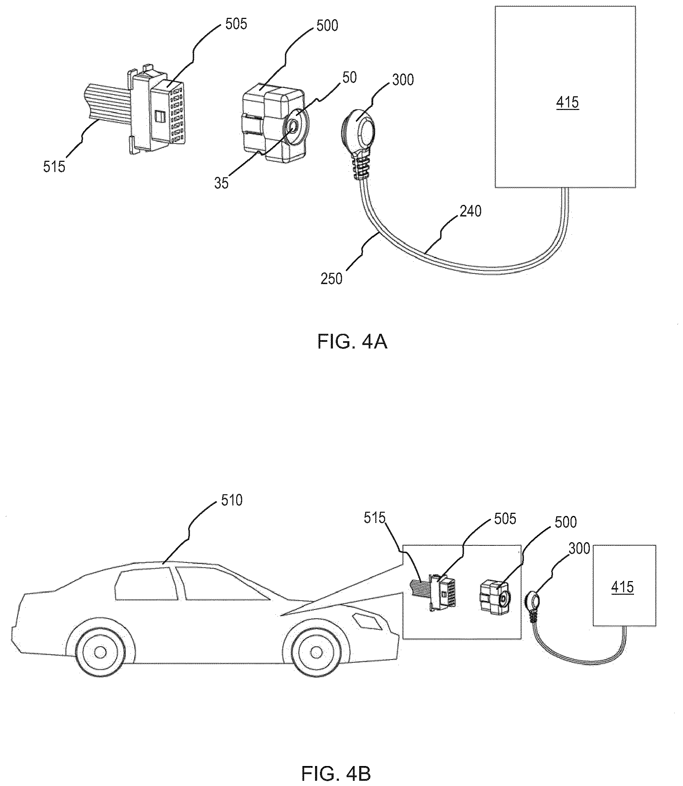

A further preferred embodiment of the invention is shown at Figs. 4A and 4B whereby a female connector (constructed generally according to the diagram of Fig. 1A) is incorporated into the housing of a connector 500 that is capable of connecting to an OBD-II port 505 of a vehicle 510. Applicant has recognised that the OBD-II port of a vehicle allows for electrical contact to be made with the battery of an internal combustion engine vehicle irrespective of the ignition status of the vehicle. In many vehicles, electrical connection to the battery via accessories (such as a cigarette light socket) is not possible where the car is turned off and parked. Thus, it is not possible to charge or maintain a vehicle battery when a car is sitting unattended and parked. The present invention provides a housing with a connector (such as the female connector of Fig. 1A), whereby the housing is configured to make electrical contact with a pin of the OBD-II port that capable of conducting power to the vehicle battery. Typically, pin 16 is connected via the vehicle wiring harness 515 to the positive pole of the vehicle battery. Accordingly, the housing 500 is configured to make electrical contact between the pin receiving portion 35 and pin 16 of the OBD-II port 505. Typically, pin 4 is connected via the vehicle wiring harness 515 to the vehicle chassis (i.e. ground). Accordingly, the housing 500 is configured to make electrical contact between the ring-shaped plate 50 and pin 4 of the OBD-II port 505.

The OBD-II port is normally accessible from within the vehicle 510 passenger cabin, as shown in Fig. 3B. Accordingly, the male connector 300 (connected to the mains power supply 415) can be coupled to the OBD-II complaint connector housing 500 (via the vehicle window, for example) to allow for the vehicle battery (not shown) to be charged or maintained. In some embodiments, the mains power supply 415 is replaced by a solar panel capable of outputting a charging current at the required voltage. In such embodiments, the solar panel may be place on the vehicle dash board, thereby allowing the vehicle to remain closed and locked while charging.

Given that the OBD-II port of a vehicle is concealed to some extent (typically under the dash) finding the port and then properly aligning a connector is difficult, especially given that there is often very limit light about the port. The magnetic attraction provided by the OBD-II compliant housing of this embodiment of the invention means that the user is not required to bend downwardly so as to visualise the connectors and carefully align same in order to couple. Instead, the user may simply reach under the dash in the general area of the OBD-II port whilst holding the charging connector 300. Upon feeling the connector housing 500, the user passes the charging connector 300 over the housing 500 surface until a magnetic attraction is felt. The user then release the charging connector 300 allowing the connector 300 to align with the magnetic field of the connector 500 and then further allow the connector 300 to be attracted toward the housing 500 until it snaps into place and charging can commence.

The OBD-II complaint connector housing 500 may be configured to remain permanently or semi-permanently on the port 505. To prevent debris from entering the port 505 the housing 500 may be configured to completely close over the port 505 opening. Of course, the housing 500 may be temporarily removed when it is necessary to attach a diagnostic device to the OBD-II port 505 so as to retrieve diagnostic codes stored in the vehicle engine management system.

The present connectors may be used for monitoring battery voltage, either alone or in combination with the function of battery charging. For example, the monitoring function may occur when a charger is connected to the connector in which case the user may monitor the progress or charging (for example, by the increase in voltage reported). In some embodiments, the voltage is not reviewed by a user and is used by associated regulation circuitry to alter the current. When fully charged (as detected by the monitoring function), the current may be switched off, or decreased so as to provide a float charge only.

In embodiments having a monitoring function, the voltage monitoring circuitry may be in data communication with wireless data transmission circuitry such as that capable of transmitting data via BlueTooth™ or Ant™ or WiFi™ protocol. In this way, battery voltage data may be transmitted to a user mobile device (such as a smart phone) or a user computer to allow a user to access voltage information. In such embodiments, application software installed onto the mobile device or computer accepts the wirelessly transmitted data and presents same on a display of the mobile device or computer. In some embodiments, the application software is configured to display an alert (such as by way of push notification) to prompt a user to connect a charger so as to fully charge the battery. The alert may be triggered if the battery voltage falls below a certain level, such as 12.5 volts.

Connectors configured to interface with an OBD-II port are particularly suitable given the constant supply of voltage for (i) monitoring and (ii) operation of the wireless data transmission circuitry. Of course, this embodiment places a parasitic load on the vehicle circuitry and for that reason low energy BlueTooth™ hardware and protocols are preferred.

It will be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Thus, while there has been described what are believed to be the preferred embodiments of the invention, those skilled in the art will recognize that other and further modifications may be made thereto without departing from the spirit of the invention, and it is intended to claim all such changes and modifications as fall within the scope of the invention. Functionality may be added or deleted from diagrams and operations may be interchanged among functional blocks. Steps may be added or deleted to methods described within the scope of the present invention.

Although the invention has been described with reference to specific examples, it will be appreciated by those skilled in the art that the invention may be embodied in many other forms. For example, the skilled person is enabled (with only routine optimization methodology) to configure any of the connectors or charging systems to operate at any desired scale, or for any desired vehicle battery. The connectors any associated hardware may be configured so as to operate at currents of at least about 0.1, 0.2, 0.3, 0.4, 0.5, 0.6, 0.7, 0.8, 0.9, 1.0, 1.5, 2.0, 2.5, 3.0, 3.5, 4.0, 4.5, 5.0, 5.5, 6.0, 6.5, 7.0, 7.5, 8.0, 8.5, 9.0, 9.5 or 10.0 Amps. Preferably, the connectors and any associated hardware are configured to operate at currents between about 1.0 Amp and about 5 Amps. As will be understood, relative low currents are useful in trickle charging a battery while relatively high currents will be required to recharge a depleted battery especially in the early phases of charging. Where high currents are expected, components of the connectors which are conductive a sized so as to allow such current to pass without the generation of adverse amounts of heat or connector failure. Voltages passing through the connector will typically be greater than 12V, and may be at least about 13, 14, 15, 16, 17, 18, 19, 20, 21, 22, 23, 24,25, 26, 27, 28, 29, 30, 31, 32, 33, 34, 35, 36, 37, 38, 39, 40, 41, 42, 43, 44, 45, 46, 47, 48, 49 or 50 V. The voltage is chosen so as to provide sufficient electromotive force (EMF) to effectively charge the vehicle battery.

The present invention, in one aspect, will now be described by way of reference to the following clauses.
1. An electrical connector for charging or monitoring a vehicle battery, the electrical connector comprising a first conducting portion configured to conduct sufficient electrical energy to charge or maintain or monitor the voltage of a vehicle rechargeable battery, and a magnetically attractive portion configured to be attracted to a complementary magnetically attractive portion on another connector.
2. The electrical connector of clause 1, wherein the first conducting portion is disposed on or over a surface of the magnetically attractive portion.
3. The electrical connector of clause 1 or clause 2, wherein the magnetically attractive portion is also the first conductive portion.
4. The electrical connector of any one of clauses 1 to 3, wherein the first conductive portion is a metallic plate disposed on or over a surface of the magnetically attractive portion.
5. The electrical connector of any one of clauses 1 to 4, wherein, in use, the first conductive portion conducts negative charge.
6. The electrical connector of any one of clauses 1 to 5 comprising a second conducting portion which, in use, conducts a charge opposite to that of the first conducting portion.
7. The electrical connector of clause 6, wherein the second conducting portion is a male conducting portion.
8. The electrical connector of clause 7, wherein the male conducting portion extends outwardly from the connector and extends beyond the first conducting portion.
9. The electrical connector of clause 7 or clause 8, wherein the male conducting portion is biased outwardly.
10. The electrical connector of any one of clauses 6 to 9, wherein the second conducting portion is a female conducting portion.
11. The electrical connector of any one of clauses 6 to 10, wherein the second conducting portion comprises a space adapted to receive a male conducting portion.
12. The electrical connector of any one of clauses 6 to 11, wherein the second conducting portion is disposed adjacent to the magnetically attractive portion.
13. The electrical connector of any one of clauses 6 to 12, wherein the magnetically attractive portion partially or completely surrounds the second conductive portion
14. The electrical connector of any one of clauses 6 to 13, wherein the first conductive portion partially or completely surrounds the second conductive portion.
15. The electrical connector of any one of clauses 1 to 14, associated with a housing of a connector associated with a processor or electronic memory of a vehicle.
16. The electrical connector of clause 15, wherein the processor or electronic memory is part of an engine management system of a vehicle.
17. The electrical connector of clause 15 or clause 16, wherein the connector associated with a processor or electronic memory of a vehicle is an on-board diagnostics (OBD) connector.
18. The electrical connector of any one of clauses 15 to 17, wherein the connector associated with a processor or electronic memory comprises a ground (chassis) connection and a battery connection, and the first connector is in electrical connection with the ground (chassis) connection and/or the second connector is in electrical connection with the battery connection and/or the second connector is in electrical connection with the ground (chassis) connection and/or the first connector is in electrical connection with the battery connection.
19. The electrical connector of any one of clauses 1 to 18, wherein the magnetically attractive portion is a magnet or a magnetisable metal.
20. A connection system for connecting a rechargeable vehicle battery to a power supply or a battery monitor, the system comprising a first connector of any one of clauses 1 to 19 and a second connector of any one of clauses 1 to 19, wherein the first connector and second connector are each configured to form a mutual magnetic coupling, the coupling being such that an electrical connection is made between the first and second connectors.
21. The connection system of clause 20 wherein the magnetically attractive portion of the first connector is a magnet, and the magnetically attractive portion of the second connector is a magnet having an opposite polarity to the magnet of the first connector.
22. A vehicle having a rechargeable battery, the rechargeable battery being in electrical connection with the connector of any one of clauses 1 to 19.
23. A power supply for charging the battery of a vehicle, the power supply being in electrical connection with the connector of any one of clauses 1 to 19.
24. A method of charging a vehicle battery, the method comprising the steps of:
   connecting the connector of the power supply of clause 23 to the connector of the vehicle of clause 22 by causing or allowing the magnetically attractive portions of the first and second connectors to contact, or nearly contact each other such that the conductive portions of the first and second connectors form an electrical connection, and
   allowing electrical current to flow from the power supply to the vehicle rechargeable battery.
25. The method of clause 24 comprising the step of the user manually breaking the magnetic attraction between the magnetically attractive portions of the first and second connectors after a period.
26. A device for monitoring the battery of a vehicle, the device comprising an electrical and/or electronic means for detecting a battery parameter being in electrical connection with the connector of any one of clauses 1 to 19.
27. The device of clause 26 wherein the battery parameter is battery voltage.
28. A method of monitoring a parameter of a vehicle battery, the method comprising the step of connecting the device of clause 26 or clause 27 to a vehicle battery.
29. A method of providing a recharging or a monitoring port to a vehicle having a rechargeable battery, the method comprising the step of securing the electrical connector of any one of clauses 1 to 19 to a vehicle.
30. The method of clause 29 comprising the step of connecting a rechargeable battery of the vehicle to the electrical connector.

## Claims

1. An electrical connector for charging or monitoring a vehicle battery, the electrical connector comprising a first conducting portion configured to conduct sufficient electrical energy to charge or maintain or monitor the voltage of a vehicle rechargeable battery, and a magnetically attractive portion configured to be attracted to a complementary magnetically attractive portion on another connector.

2. The electrical connector of claim 1, wherein the first conducting portion is disposed on or over a surface of the magnetically attractive portion.

3. The electrical connector of claim 1 or claim 2, wherein the magnetically attractive portion is also the first conductive portion.

4. The electrical connector of any one of claims 1 to 3, wherein the first conductive portion is a metallic plate disposed on or over a surface of the magnetically attractive portion; preferably wherein, in use, the first conductive portion conducts negative charge.

5. The electrical connector of any one of claims 1 to 4 comprising a second conducting portion which, in use, conducts a charge opposite to that of the first conducting portion;

6. The electrical connector of claim 5, wherein the second conducting portion is a male conducting portion; preferably wherein the male conducting portion extends outwardly from the connector and extends beyond the first conducting portion; preferably wherein the male conducting portion is biased outwardly.

7. The electrical connector of claim 5 or claim 6, wherein the second conducting portion is a female conducting portion; preferably wherein the second conducting portion comprises a space adapted to receive a male conducting portion; preferably wherein the second conducting portion is disposed adjacent to the magnetically attractive portion; preferably wherein the magnetically attractive portion partially or completely surrounds the second conductive portion; preferably wherein the first conductive portion partially or completely surrounds the second conductive portion.

8. The electrical connector of any one of claims 1 to 7, associated with a housing of a connector associated with a processor or electronic memory of a vehicle; preferably wherein the processor or electronic memory is part of an engine management system of a vehicle; preferably wherein the connector associated with a processor or electronic memory of a vehicle is an on-board diagnostics (OBD) connector; preferably wherein the connector associated with a processor or electronic memory comprises a ground (chassis) connection and a battery connection, and the first connector is in electrical connection with the ground (chassis) connection and/or the second connector is in electrical connection with the battery connection and/or the second connector is in electrical connection with the ground (chassis) connection and/or the first connector is in electrical connection with the battery connection; preferably wherein the magnetically attractive portion is a magnet or a magnetisable metal.

9. A connection system for connecting a rechargeable vehicle battery to a power supply or a battery monitor, the system comprising a first connector of any one of claims 1 to 8 and a second connector of any one of claims 1 to 8, wherein the first connector and second connector are each configured to form a mutual magnetic coupling, the coupling being such that an electrical connection is made between the first and second connectors; preferably wherein the magnetically attractive portion of the first connector is a magnet, and the magnetically attractive portion of the second connector is a magnet having an opposite polarity to the magnet of the first connector.

10. A vehicle having a rechargeable battery, the rechargeable battery being in electrical connection with the connector of any one of claims 1 to 8.

11. A power supply for charging the battery of a vehicle, the power supply being in electrical connection with the connector of any one of claims 1 to 8.

12. A method of charging a vehicle battery, the method comprising the steps of:
connecting the connector of the power supply of claim 11 to the connector of the vehicle of claim 10 by causing or allowing the magnetically attractive portions of the first and second connectors to contact, or nearly contact each other such that the conductive portions of the first and second connectors form an electrical connection, and
allowing electrical current to flow from the power supply to the vehicle rechargeable battery; preferably comprising the step of the user manually breaking the magnetic attraction between the magnetically attractive portions of the first and second connectors after a period.

13. A device for monitoring the battery of a vehicle, the device comprising an electrical and/or electronic means for detecting a battery parameter being in electrical connection with the connector of any one of claims 1 to 8; preferably wherein the battery parameter is battery voltage.

14. A method of monitoring a parameter of a vehicle battery, the method comprising the step of connecting the device of claim 13 to a vehicle battery.

15. A method of providing a recharging or a monitoring port to a vehicle having a rechargeable battery, the method comprising the step of securing the electrical connector of any one of claims 1 to 8 to a vehicle.; preferably comprising the step of connecting a rechargeable battery of the vehicle to the electrical connector.
